# EUROPEAN PATENT APPLICATION

(11) **EP 3 725 912 A1**
(43) Date of publication of application: **21.10.2020**
(21) Application number: 18889725.0
(22) Date of filing: 30.10.2018
(51) Int. Cl.: C23C 18/12, C23C 18/18, C25D 5/54, H05K 3/18

(54) **COATING AGENT FOR FORMING OXIDE FILM, METHOD FOR PRODUCING OXIDE FILM, AND METHOD FOR PRODUCING METAL-PLATED STRUCTURE**

(30) Priority: 12.12.2017 JP 2017238057
(71) Applicant: JCU Corporation, Tokyo 1100015 (JP)
(72) Inventor: CORDONIER Christopher, Kawasaki-shi, Kanagawa 215-0033 (JP); OKABE Kyohei, Kawasaki-shi, Kanagawa 215-0033 (JP); MORITA Asami, Kawasaki-shi, Kanagawa 215-0033 (JP); TERASHIMA Yoshitaka, Kawasaki-shi, Kanagawa 215-0033 (JP)
(74) Representative: Ter Meer Steinmeister & Partner
(86) International application number: PCT/JP2018/040362
(87) International publication number: WO 2019/116759

(57) **Abstract**

Provided are: a coating agent for forming an oxide film; a method for producing an oxide film; and a method for producing a metal-plated structure, wherein the stability of the coating agent can be enhanced, and an oxide film which can be plated and has high adhesion to a substrate can be easily formed. The coating agent for forming an oxide film is a liquid coating agent, essentially contains titanium atoms, and optionally contains silicon atoms and copper atoms, wherein the ratio of the sum of the titanium atoms and copper atoms to the silicon atoms is 1:0-3:2. The method for producing an oxide film comprises a step for applying the coating agent to a substrate and heating to form an oxide film. The method for producing a metal-plated structure comprises: a metal-film-forming step for forming a metal film on the oxide film; and a baking step for baking the metal film.

## Description

### TECHNICAL FIELD

The present invention relates to a coating agent for forming an oxide film, a method for producing an oxide film, and a method for producing a metal-plated structure. More specifically, the present invention relates to a coating agent and method for forming a metal-plated structure by a process that includes forming an oxide film on a surface of a substrate such as a glass, ceramic, or silicon substrate and metalizing a surface of the oxide film.

### BACKGROUND ART

Techniques for metal plating on substrates are used in the field of printed electronic circuits such as fine wiring circuits on glass or ceramic substrates. Such techniques have found applications such as liquid crystal displays, semiconductor devices, and other electronic devices.

A technique used for metal plating on a substrate includes, for example, applying a coating agent (coating solution) made from zinc acetate dihydrate to the surface of a non-conducting substrate, then baking the coating to form a zinc oxide thin film, and performing plating on the thin film to form a metal film, so that the surface of the non-conducting substrate is modified by metallization (see Patent Document 1).

Patent Document 1: Japanese Unexamined Patent Application, Publication No. 2016-533429

### DISCLOSURE OF THE INVENTION

### Problems to be Solved by the Invention

Unfortunately, the technique disclosed in Patent Document 1 has difficulty in preparing a stable coating solution from zinc acetate dihydrate. In addition, blister formation can easily occur between the substrate and the zinc oxide thin film formed through applying the coating solution on the surface of the substrate, and the adhesion is low between the substrate and the zinc oxide thin film.

It is an object of the present invention, which has been made under such circumstances, to provide a coating agent for forming an oxide film and methods for producing an oxide film and a metal-plated structure, which allow an increase in coating agent stability, an increase in adhesion to substrate, and easy formation of an oxide film on which plating is possible.

### Means for Solving the Problems

The present inventors have completed the present invention based on findings that a liquid coating agent for forming an oxide film on a substrate can have increased stability when the ratio of the total of titanium and copper atoms to silicon atoms in the coating agent falls within a certain range and such a coating agent makes it easy to form an oxide film which has high adhesion to a substrate and on which plating is possible.
(1) A first aspect of the present invention is directed to a liquid coating agent for forming an oxide film on a substrate, the liquid coating agent including titanium atoms as an essential component and optionally including silicon and copper atoms, wherein the ratio of the total number of the titanium and copper atoms to the number of the silicon atoms is between 3:2 and 1:0.
(2) A second aspect of the present invention is directed to the coating agent for forming an oxide film according to the first aspect, wherein the ratio of the total number of the titanium and copper atoms to the number of the silicon atoms is between 7:3 and 20:1.
(3) A third aspect of the present invention is directed to the coating agent for forming an oxide film according to the first or second aspect, further including a solvent including one or more of water, alcohols, ketones, ethers, esters, aromatic compounds, and nitrogen-containing solvents.
(4) A fourth aspect of the present invention is directed to the coating agent for forming an oxide film according to any one of the first to third aspects, which is for use in improving adhesion between the substrate and a metal film.
(5) A fifth aspect of the present invention is directed to a method for producing an oxide film, including the steps of applying the coating agent for forming an oxide film according to any one of the first to fourth aspects to a substrate and heating the coating agent to form an oxide film.
(6) A sixth aspect of the present invention is directed to a method for producing a metal-plated structure by forming a metal film on at least part of a surface of a substrate with an oxide film interposed between the substrate and the metal film, the method including: an oxide film forming step that includes applying the coating agent for forming an oxide film according to any one of the first to fourth aspects to a surface of the substrate to form an oxide film; a metal film forming step that includes forming a metal film on the oxide film; and a metal film baking step that includes baking the metal film.
(7) A seventh aspect of the present invention is directed to the method according to the sixth aspect, wherein the metal film forming step includes depositing metal on a catalyst deposited on the oxide film to form the metal film.
(8) An eighth aspect of the present invention is directed to the method according to the seventh aspect, wherein copper (Cu), a metal element having a standard electrode potential positively more than that of copper (Cu), or a compound of copper and/or the metal element is used as the catalyst.
(9) A ninth aspect of the present invention is directed to the method according to the eighth aspect, wherein the catalyst is deposited in an amount of 0.5 mg/m² or more on a metal basis on the oxide film.

### Effects of the Invention

The present invention makes it possible to provide a coating agent for forming an oxide film and methods for producing an oxide film and a metal-plated structure, which allow an increase in coating agent stability, an increase in adhesion to a substrate, and easy formation of an oxide film on which plating is possible.

The present invention also makes it possible to reduce dissolution of an oxide film into a plating solution in the process of plating on an oxide film, which is produced from the coating agent, to form a metal film. This facilitates the formation of the metal film and prolongs the life of the plating solution.

### PREFERRED MODE FOR CARRYING OUT THE INVENTION

Hereinafter, embodiments of the present invention will be described. It will be understood that the embodiments are shown only by way of example and may be altered or modified in various manners without departing from the technical scope of the present invention.

### <<Coating Agent for Forming Oxide Film>>

The coating agent of the present invention for forming an oxide film includes (A) at least one selected from an oxide and an oxide precursor and (B) a solvent.

### <(A) Oxide and Oxide Precursor>

The oxide and the oxide precursor for use in the coating agent for forming an oxide film contain titanium atoms as an essential component and optionally contain silicon and copper atoms and have a ratio of the total number of titanium and copper atoms to the number of silicon atoms of 3:2 to 1:0.

In this regard, when the ratio of the total number of titanium and copper atoms to the number of silicon atoms ((the number of titanium and copper atoms):(the number of silicon atoms)) is 3:2 or more than 3:2, the coating agent applied to a substrate can form an oxide film with less blister formation between the substrate and the oxide film, so that increased adhesion is achieved between the substrate and the oxide film. In addition, a metal film can be easily formed by electroless plating on the oxide film. Therefore, the ratio of the total number of titanium and copper atoms to the number of silicon atoms is preferably 3:2 or more than 3:2 (or the ratio of the number of Si atoms to the number of Ti and Cu atoms is preferably 0.66 or less), more preferably 7:3 or more than 7:3 (or the ratio of the number of Si atoms to the number of Ti and Cu atoms is more preferably 0.43 or less).

On the other hand, the coating agent of the present invention for forming an oxide film may be free of silicon atoms. However, when the ratio of the total number of titanium and copper atoms to the number of silicon atoms ((the number of titanium and copper atoms):(the number of silicon atoms)) is 20:1 or less than 20:1, the coating agent can form an oxide film with an increased mechanical strength, which makes it possible to prevent an oxide fracture-induced decrease in adhesion between a substrate and a metal film, particularly when a more porous oxide film is formed and the metal film is formed thereon. In addition, for example, the catalyst can be deposited in a larger amount on the oxide film so that a metal film can be formed with higher adhesion to the oxide film and to the substrate. Therefore, the ratio of the total number of titanium and copper atoms to the number of silicon atoms is preferably 1:0 or less than 1:0 (or the ratio of the number of Si atoms to the number of Ti and Cu atoms is preferably more than 0), more preferably 20:1 or less than 20:1 (or the ratio of the number of Si atoms to the number of Ti and Cu atoms is more preferably 0.05 or more), even more preferably 10:1 or less than 10:1 (or the ratio of the number of Si atoms to the number of Ti and Cu atoms is even more preferably 0.10 or more), further more preferably 7:1 or less than 7:1 (or the ratio of the number of Si atoms to the number of Ti and Cu atoms is further more preferably 0.14 or more).

Besides the oxide, the coating agent of the present invention for forming an oxide film may contain an oxide precursor. A compound capable of functioning as a source of a corresponding oxide may be used as an oxide precursor. The coating agent may contain, as an oxide precursor, a compound capable of undergoing a reaction to form an oxide during a period from application to the substrate to deposition of the catalyst. Examples of such a compound include soluble salts of a metal or silicon, which are roughly classified into organic soluble salts and inorganic soluble salts. Examples of organic soluble salts include alkoxides such as methoxides, ethoxides, propoxides, and butoxides; carboxylic acid compounds such as acetate salts; diol compounds; polyol compounds; complexes such as diketone complexes, hydroxyketone complexes, and hydroxycarboxylic acid complexes; and hydrolysates thereof. Examples of inorganic soluble salts include halides such as chlorides, bromides, and iodides; and nitrates.

In the coating agent of the present invention for forming an oxide film, an oxide precursor, in particular, a metal alkoxide or the like can be easily dissolved or dispersed, which makes it possible to uniformly form a thinner oxide film on the substrate surface.

The concentration of the oxide and the oxide precursor in the coating agent for forming an oxide film is preferably 10 mmol/L or more, more preferably 50 mmol/L or more, even more preferably 100 mmol/L or more, when expressed as the number of moles of metal atoms (including silicon atoms) in 1 liter of the coating agent. On the other hand, the concentration of the oxide and the oxide precursor preferably has an upper limit of 1,000 mmol/L or less, more preferably 800 mmol/L or less.

The concentration of titanium atoms as an essential component in the coating agent of the present invention for forming an oxide film is preferably 10 mmol/L or more, more preferably 50 mmol/L or more, even more preferably 80 mmol/L or more, when expressed as the number of moles of titanium atoms in 1 liter of the coating agent. On the other hand, the concentration of titanium atoms preferably has an upper limit of 1,000 mmol/L or less, more preferably 800 mmol/L or less, even more preferably 600 mmol/L or less.

The content of copper atoms, which are optionally contained in the coating agent of the present invention for forming an oxide film, may be preferably 10 mmol/L or more, more preferably 20 mmol/L or more, even more preferably 30 mmol/L or more, when expressed as the number of moles of copper atoms in 1 liter of the coating agent. On the other hand, the concentration of copper atoms preferably has an upper limit of 200 mmol/L or less, more preferably 150 mmol/L or less, even more preferably 100 mmol/L or less.

The content of silicon atoms, which are optionally contained in the coating agent of the present invention for forming an oxide film, may be preferably more than 0 mmol/L, more preferably 10 mmol/L or more, even more preferably 30 mmol/L or more, when expressed as the number of moles of silicon atoms in 1 liter of the coating agent. On the other hand, the concentration of silicon atoms preferably has an upper limit of 200 mmol/L or less, more preferably 150 mmol/L or less, even more preferably 100 mmol/L or less.

The oxide and the oxide precursor may include a compound that allows metal atoms other than titanium (Ti), copper (Cu), and silicon (Si) to remain in an oxide layer. Examples of metal atoms that may be contained in the oxide and the oxide precursor besides titanium (Ti), copper (Cu), and silicon (Si) include zirconium (Zr), aluminum (Al), and tin (Sn). The content of atoms of each of these metals may be 10 mmol/L or less when expressed as the number of moles of metal atoms in 1 liter of the coating agent for forming an oxide film. On the other hand, to form an oxide film with higher adhesion to the substrate, the coating agent is more preferably free of these metal atoms.

On the other hand, zinc (Zn) atoms may reduce the stability of the coating agent and may cause dissolution of zinc oxide in the process of forming a metal film by electroless plating or the like on the oxide film, which may make it difficult to form the metal film and may degrade the electrical performance or appearance of the metal film being formed. Therefore, the content of zinc atoms in the coating agent for forming an oxide film is preferably 100 mmol/L or less, more preferably 80 mmol/L or less, even more preferably 60 mmol/L or less, when expressed as the number of moles of zinc atoms in 1 liter of the coating agent for forming an oxide film. Most preferably, the coating agent is free of zing atoms.

The oxide or oxide precursor may include a mixture of two or more compounds. To make it easy to manage the concentration of a solute or dispersed material in a solution or dispersion that forms the coating agent, however, a single compound is preferably used as the oxide or oxide precursor.

### <(B) Solvent>

The solvent for use in the coating agent for forming an oxide film may be one in which the oxide or oxide precursor can be dissolved or dispersed. In particular, a solvent with which the substrate is sufficiently wettable is preferably used. It is also preferred to use a solvent that is liquid in a room temperature range (15 to 30°C), which makes it possible to prepare and store the coating agent at room temperature.

The solvent is preferably polar so that the oxide or oxide precursor can be easily dissolved or dispersed. More specifically, water or a polar organic solvent is preferably used as the solvent. Examples of such a polar organic solvent include alcohols such as ethanol, propanol, isopropanol, n-butanol, and glycol; ketones such as methyl ethyl ketone, methyl isobutyl ketone, and isophorone; esters and ethers such as methoxyethanol, 2-ethoxyethanol, 2-n-butoxyethanol, ethyl lactate, 2-ethoxyethyl acetate, and γ-butyrolactone; aromatic compounds such as toluene and xylene; and nitrogen-containing solvents such as dimethylformamide and N-methylpyrrolidone. A mixture of two or more of these solvents may also be used.

The solvent may be a water-based solvent, more specifically, a mixed solvent of water and a liquid having high compatibility with water. In particular, the solvent may be a mixture of water and a polar organic solvent.

In this case, when made water-soluble by using a water-based solvent, the coating agent for forming an oxide film preferably contains, as the oxide precursor, a complex including a metal atom (including a silicon atom) and a ligand such as lactic acid, citric acid, or EDTA; a hydrolysate of a metal or silicon salt; or a chloride of a metal or silicon. On the other hand, when prepared using an organic solvent, the coating agent for forming an oxide film preferably contains, as the oxide precursor, an alkoxide, diol compound, complex, polyol compound, diketone complex, or hydroxyketone complex of a metal or silicon.

### <(C) Other Components>

The coating agent for forming an oxide film according to the present invention may contain any conventionally known compound as a component other than the above.

### [Surfactant]

For example, the coating agent for forming an oxide film may contain a surfactant (leveler) in order to form an oxide film with improved uniformity and improved wettability on the substrate surface. In particular, when the coating agent for forming an oxide film is water-soluble, a surfactant is sometimes necessary for formation of a uniform oxide film under reduced surface tension. Also when the coating agent for forming an oxide film contains the oxide, a surfactant is sometimes necessary for formation of a stable colloidal dispersion.

Examples of the surfactant include, but are not limited to, modified dimethylpolysiloxanes (KP-341 and KP-104 manufactured by Shin-Etsu Chemical Co., Ltd.), fluorocarbons, and polyethers (Triton X-100 manufactured by Sigma-Aldrich, Inc.).

The coating agent for forming an oxide film preferably has a surfactant concentration in the range of 0.0001 to 5% by mass, more preferably in the range of 0.0005 to 3% by mass, based on the total mass of the coating agent.

### [Acid and Base]

The coating agent for forming an oxide film may contain an acid or base in order for the oxide precursor in the coating agent to undergo polycondensation reaction so that the molecular weight of the product can be adjusted for adjustment of the porosity of the oxide film, in order to stabilize the metal atoms by chelation, or in order to control the surface charge condition of the oxide or oxide precursor.

Examples of the acid or base which may be added to the coating agent for forming an oxide film include, but are not limited to, inorganic acids such as hydrochloric acid, sulfuric acid, and phosphoric acid; organic acids such as acetic acid, lactic acid, 2-hydroxyisobutyric acid, methoxyethoxyacetic acid, and γ-butyrolactone acid; condensates thereof; and sodium hydroxide, potassium hydroxide, ammonia, amines, and other bases.

Among them, a known compound capable of undergoing chelation with the metal atom for forming an oxide film may be used as a chelating agent. For example, the chelating agent is preferably at least one of lactic acid, citric acid, 2-hydroxyisobutyric acid, methoxyethoxyacetic acid, ethyl 3,4-dihydroxybenzoate, triethanolamine, 3-hydroxy-2-butanone (acetoin), maltol, catechol, and 2,4-pentanedione. In particular, the use of 3-hydroxy-2-butanone as the chelating agent allows the oxide film to have a maximum porosity.

### [Photosensitive Material]

The coating agent for forming an oxide film may also contain a known photosensitive material in order to enable patterning of the resulting oxide film.

### <Properties and Applications of the Coating Agent for Forming Oxide Film>

The coating agent for forming an oxide film according to the present invention is prepared in the form of a solution or dispersion having fluidity. In this regard, the viscosity of the coating agent for forming an oxide film is preferably adjusted to fall within a range suitable for forming a coating film.

The coating agent for forming an oxide film according to the present invention can be used not only in oxide film production to form an oxide film with improved adhesion to a substrate but also in, for example, a metal-plated structure producing method as described later to form a metal film on the oxide film with improved adhesion between the metal film and the substrate.

### <<Method for Producing Oxide Film>>

The method of the present invention for producing an oxide film includes a substrate preparing step (S1) that includes preparing a substrate and an oxide film forming step (S2) that includes applying, to the substrate, the coating agent described above for forming an oxide film and heating the coating agent to form an oxide film.

### <(S1) Substrate Preparing Step>

The substrate preparing step (S1) includes preparing a substrate for use in oxide film formation and optionally subjecting the substrate to a pretreatment as needed.

### [Material of Substrate]

The substrate for use in oxide film formation may be a non-metallic inorganic material that can withstand the heat treatment temperature as shown later, such as glass, ceramics, and a silicon semiconductor material. In particular, when a metal film for use as wiring or the like in an electronic circuit is formed on the substrate with an oxide film interposed therebetween, the substrate used is preferably a non-conducting material, for example, with an electric resistivity of 10³ Ω·m or more, more preferably 10⁶ Ω·m or more in order to prevent conduction through the substrate.

Examples of the glass include amorphous glass such as quartz glass, silica glass, borosilicate glass, aluminosilicate glass, aluminoborosilicate glass, soda lime glass (soda lime glass), float glass, fluoride glass, phosphate glass, borate glass and chalcogenide glass; and glass ceramics containing a crystalline phase precipitated in glass.

Examples of the ceramics include oxide ceramics including alumina, beryllia, ceria, and zirconia; and non-oxide ceramics such as carbides, borides, nitrides, and silicides. Specific examples of the ceramics include alumina, aluminum nitride, β-TCP (β-tricalcium phosphate), and barium titanate (BaTiO₃).

Examples of the silicon semiconductor material include silicon wafers widely used in the semiconductor industry, which may have an oxidized surface and may contain a dopant.

The substrate for use in oxide film formation may be not only a single sheet-shaped material but also a stack of two or more sheet-shaped substrates.

### [Pretreatment of Substrate]

The substrate for use in oxide film formation is preferably prepared to have a smooth surface in order for a metal film to have increased adhesion. More specifically, when a glass or silicon semiconductor material substrate is used, the surface of the substrate preferably has an average surface roughness Ra in the range of 0.1 to 200 nm, more preferably in the range of 1 to 100 nm, even more preferably in the range of 5 to 50 nm. On the other hand, when a ceramic substrate is used, the surface of the substrate preferably has an average surface roughness Ra of 1,000 nm or less, more preferably 600 nm or less. The surface smoothness of the substrate may be increased using, for example, known polishing means.

The substrate is also preferably subjected to cleaning before being brought into contact with the coating agent for forming an oxide film. Known methods may be used to clean the substrate, including, for example, a method of immersing the substrate in a surfactant-containing solution, a method of immersing the substrate in a polar organic solvent or a mixture thereof, a method of immersing the substrate in an alkaline solution, and a combination of two or more of these methods.

### <Oxide Film Forming Step (S2)>

The oxide film forming step (S2) includes a coating film forming step that includes applying the coating agent for forming an oxide film to the substrate to form a coating film; and then a coating film baking step that includes heating the coating film to form an oxide film.

### [Coating Film Forming Step]

The coating film forming step includes applying the coating agent for forming an oxide film to the substrate to form a coating film. The means for forming the coating film may be determined depending on the composition of the coating agent for forming an oxide film. For example, dip coating, spin coating, spray coating, curtain coating, rolling printing, screen printing, inkjet printing, and brush coating may be used to form the coating film. In particular, dip coating, slit coating, roller coating, or spin coating is preferably used when a colloid is formed in the coating agent and the coating agent should be stably applied to a larger number of substrates. When the coating agent is applied to the substrate in this manner, a film of the oxide or oxide precursor with a desired thickness can be uniformly formed on the surface of the substrate.

The temperature at which the coating agent is applied to the substrate is selected depending on the method of application, the viscosity of the coating agent, and other factors. For example, it may be 5°C or more, preferably 10°C or more, more preferably 20°C or more. On the other hand, the temperature at which the coating agent is applied to the substrate may have an upper limit of, for example, 90°C or less, preferably 80°C or less, more preferably 60°C or less.

The step of forming the coating film may be performed plural times depending on the desired thickness of the oxide layer. In particular, when the coating film is formed by applying the coating agent plural times to the substrate, the solvent should preferably be removed by drying the coating agent applied to the substrate before the coating agent is further applied thereto. This process can reduce dripping of the coating agent from the substrate when the coating agent is repeatedly applied, so that an oxide film with a desired thickness can be easily formed. On the other hand, particularly when dip coating is used to apply the coating agent to the substrate, the thickness of the coating film may be adjusted by adjusting the speed of withdrawal of the substrate.

The coating agent applied to the substrate may be dried as needed so that delamination of the formed coating film can be reduced. In this case, the temperature at which the coating agent is dried may be selected depending on the solvent used to form the coating agent. For example, it may be 30°C or more, more preferably 50°C or more. On the other hand, the temperature at which the coating agent is dried may have an upper limit of, for example, 350°C or less, more preferably 200°C or less.

### [Coating Film Baking Step]

The coating film baking step includes baking the coating film formed on the substrate to obtain an oxide film. As a result, the solvent is removed from the coating film, the oxide precursor is thermally decomposed to form an oxide, and the oxide is sintered through condensation and so on, so that a mechanically stable oxide film can be obtained, which firmly adheres to the substrate.

In particular, when the coating agent contains the oxide precursor, the oxide film may be formed on the substrate by heating the precursor in the presence of oxygen to thermally decompose the precursor after the coating agent is applied to the substrate. When the coating agent contains an oxygen atom-containing compound such as a metal alkoxide as the oxide precursor, a hydrolysate or dehydrated polycondensate of the compound may be produced in the coating agent. In this case, oxygen is not always necessary during the heating.

The coating film baking step may use any baking temperature (first baking temperature) that allows production of a desired oxide film, which may be, for example, 200°C or more, more preferably 300°C or more, even more preferably 400°C or more. In particular, when the first baking temperature is 400°C or more, the catalyst can be deposited in a larger amount on the oxide film.

On the other hand, the first baking temperature may have an upper limit of, for example, 700°C or less, more preferably 600°C or less, even more preferably 550°C or less. In particular, a first baking temperature of 550°C or less makes the oxide film less susceptible to recrystallization, so that the catalyst can be deposited in a larger amount.

In the coating film baking step, the baking time period (first baking time period) may be selected depending on the type of the oxide or oxide precursor and the first baking temperature. For example, it may be 1 minute or more, more preferably 10 minutes or more, even more preferably 30 minutes or more. On the other hand, the first baking time period may have an upper limit of, for example, 180 minutes or less, more preferably 120 minutes or less, even more preferably 90 minutes or less.

The coating film baking step may include heating with a temperature gradient until a predetermined first baking temperature is reached. In this case, heating with a temperature gradient may include raising the temperature at a constant rate until the first baking temperature is reached, changing the rate of temperature rise during at least part of the temperature gradient, or setting a time period for which a certain temperature is maintained during part of the temperature gradient. In particular, when a time period is set for which a certain temperature is maintained during the heating period, the temperature may be maintained at the drying temperature mentioned above in order to prevent the coating film from being damaged due to rapid evaporation of the solvent. After the heating with a temperature gradient, the baking is preferably performed at a predetermined first baking temperature.

In particular, the temperature gradient to the first baking temperature is preferably 50°C/minute or less, more preferably 20°C/minute or less. Accordingly, the temperature is slowly raised so that an oxide is first produced from the oxide precursor compound and then the oxide is sintered, which makes it possible to form an oxide film with higher adhesion strength to the substrate.

### [Properties of Oxide Film]

The oxide film formed on the substrate by the coating film baking step preferably has a thickness of 10 nm or more, more preferably 20 nm or more, even more preferably 30 nm or more. On the other hand, the thickness of the oxide film preferably has an upper limit of 100 nm or less, more preferably 60 nm or less, even more preferably 50 nm or less. In particular, the oxide film with a thickness of 60 nm or less can be less susceptible to cracking.

The oxide film formed on the substrate has a porous structure containing a large amount of a crystalline phase, and has covalent bonds formed through, for example, -OH group condensation, between the substrate and the oxide film. Thus, when formed on the oxide film, a metal film can be easily physically anchored to the porous structure of the oxide film, which increases the adhesion of the metal layer to a glass substrate, while the adhesion between the oxide film and the substrate is increased due to the covalent bonding of the oxide film to the substrate. Therefore, the metal film formed on the oxide film has increased adhesion to the substrate.

It is also possible to deposit a larger amount of a catalyst on the oxide layer. This can further accelerate the deposition of the metal film on the oxide film with further increased adhesion between the oxide film and the metal film. In particular, the method of the present invention for producing an oxide film allows a sufficient increase in the adhesion between the substrate and the oxide film, so that a metal film formed with increased adhesion to the oxide film can have increased adhesion to the substrate.

### <<Method for Producing Metal-Plated Structure>>

The method of the present invention for producing a metal-plated structure includes a substrate preparing step (S1) that includes preparing a substrate; an oxide film forming step (S2) that includes applying, to the substrate, the coating agent described above for forming an oxide film and heating the coating agent to form an oxide film; a metal film forming step (S3) that includes forming a metal film on the oxide film; and a metal film baking step (S4) that includes baking the metal film.

In this method, the substrate preparing step (S1) and the oxide film forming step (S2) are as described above. Hereinafter, the metal film forming step (S3) and the metal film baking step (S4) will be described.

### <Metal Film Forming Step (S3)>

The metal film forming step (S3) includes a plating step that includes performing electroless plating or electroplating on a surface of the oxide film, which is formed in the oxide film forming step (S2), to form a metal film. In this regard, the metal film forming step may be preceded by an acid or base treatment step that includes treating the oxide film with an acid- or base-containing treatment liquid or by a catalyst depositing step that incudes depositing a catalyst on the oxide film.

### [Acid or Base Treatment Step]

The acid or base treatment step is an optional step that includes treating the oxide film with a treatment liquid containing an acid or a base. The treatment of the oxide film with such a treatment liquid can modify the surface condition of the substrate on which the oxide film has been formed, so that a metal layer can be formed with further increased adhesion.

In this step, the treatment liquid is preferably a base-containing treatment liquid, more preferably an alkaline solution. The alkaline solution may be of any type having a pH of 10 or more, examples of which include an aqueous solution of a hydroxide salt such as sodium hydroxide, potassium hydroxide, or calcium hydroxide; and an aqueous solution of a carbonate. When such a base-containing treatment liquid is used, the surface of the oxide film is negatively charged, which allows adsorption of an increased amount of the catalyst when the catalyst depositing step described below is performed.

On the other hand, if the oxide film has a low titanium atom content, an acid-containing treatment liquid, preferably an acidic aqueous solution with a pH of 1 to 5 may be used as the treatment liquid. More specifically, for example, sulfuric acid, hydrochloric acid, or an organic acid such as acetic acid may be used for the treatment liquid.

In the acid or base treatment step, the oxide film may be treated by bringing the oxide film into contact with the treatment liquid, for example, at a temperature of 30°C or more and 100°C or less for 1 to 10 minutes.

### [Catalyst Depositing Step]

The catalyst depositing step is an optional step that includes depositing a catalyst on at least part of the surface of the oxide film. The catalyst deposited on the surface of the oxide film acts as a nucleus for the formation of the metal film in the metal film forming step (S3) described later, which can accelerate the deposition of the metal film on the oxide film. The deposition of the catalyst also allows formation of a metal film with further increased adhesion to the oxide film.

The catalyst for use in the catalyst depositing step may be a catalytic metal or compound thereof capable of promoting deposition of a metal film by plating on the surface of the oxide film. The catalytic metal or compound thereof may be used in the form of an aqueous solution or dispersion. The catalytic metal may be copper (Cu) or a metal element having a standard electrode potential positively more than that of copper (Cu). More specifically, palladium, copper, silver, gold, ruthenium, rhodium, osmium, iridium, and platinum may be used. Among them, palladium is more preferably used.

A specific example of the catalyst for use in the catalyst depositing step may be a palladium complex having an amino acid ligand such as arginine or lysine, which is described in, for example, Journal of The Electrochemical Society, 161 (14) D806-D812 (2014).

The amount of the catalyst deposited on the surface of the oxide film is preferably 0.5 mg/m² or more, more preferably 1.0 mg/m² or more, even more preferably 2.0 mg/m² or more on a metal basis. As used herein, the amount of the catalyst "on a metal basis" refers to the mass of catalytic metal atoms in the catalyst. Accordingly, as the amount of the catalyst deposited on the oxide film is increased, the deposition of the metal film on the oxide film can be further accelerated, and the adhesion of the metal film to the oxide film can be further increased. In particular, the method of the present invention for producing a metal-plated structure allows a sufficient increase in the adhesion between the substrate and the oxide film, so that, as the adhesion of the metal film to the oxide film is increased, the metal film can have increased adhesion to the substrate.

In this regard, when the catalyst is used in the form of an aqueous solution, the catalytic metal compound may be reduced to a metallic state by bringing a reducing agent-containing solution into contact with the catalyst on the substrate after the deposition of the catalyst. When the catalyst is used in the form of an aqueous dispersion, the catalyst may not be brought into contact with a reducing agent since the catalyst is deposited on the oxide film. Examples of the reducing agent for reducing the catalytic metal compound to a metallic state include formaldehyde, hypophosphite, glyoxylic acid, DMAB (dimethylaminoborane), and NaBH₄.

The catalytic metal compound may be reduced to a metallic state by bringing a reducing agent-containing solution into contact with the catalyst on the substrate, for example, at a temperature of 30°C or more and 100°C or less for 1 to 10 minutes.

It should be noted that the method of the present invention for producing a metal-plated structure can form a metal film with increased adhesion to the oxide film without including the catalyst depositing step. Specifically, the oxide film may include an oxide of the same metal as the component of the metal film to be formed (for example, the metal is copper, and the oxide of the metal is copper oxide), and the oxide may be reduced with a reducing agent such as anhydrous sodium borate to form nuclei of the metal. In this case, metal atoms in the oxide layer can serve as nuclei for forming the metal layer, which makes it possible to achieve increased adhesion between the oxide film and the metal film without using any catalyst.

### [Plating Step]

The plating step includes performing electroless plating or electroplating on a surface of the oxide film to form a metal film. The method of the present invention for producing a metal-plated structure can reduce the dissolution of the oxide film into the plating solution during plating on the oxide film. This facilitates the formation of the metal film and prolongs the life of the plating solution.

In this regard, specifically when the substrate and the oxide film used are non-conducting, it is preferred in terms of process efficiency that electroless plating be performed on the surface of the oxide film to form a metal film and then using the metal film as an electrode, electroplating be performed to form another metal film.

### (Electroless Plating)

Specifically, the electroless plating may be a method that includes bringing the oxide film, on which the catalyst is optionally deposited, into contact with a plating solution containing a chemically reducing agent to deposit a metal film on the surface of the oxide film.

The plating solution may be a solution containing a reducing agent and ions of a metal to be deposited as a metal film. The metal ions may be, for example, Cu ions, Ni ions, Co ions, or Ag ions in a solution. Examples of the reducing agent include formaldehyde, hypophosphite, glyoxylic acid, DMAB (dimethylaminoborane), and NaBH₄.

The plating solution may contain a pH adjusting agent, a complexing agent, an accelerating agent, and a stabilizing agent. Example of the stabilizing agent include mercaptobenzothiazole, thiourea, various other sulfur compounds, cyanides and/or ferrocyanides and/or cobalt cyanide salts, polyethylene glycol derivatives, heterocyclic nitrogen compounds, methylbutynol, and propionitrile.

The plating solution may be prepared such that, if it is brought into contact with the substrate with the oxide film formed thereon, a metal film will form at a specific deposition rate. In this regard, the electroless plating preferably forms a metal film at a deposition rate of 10 nm/min or more, more preferably 15 nm/min or more. In particular, at a deposition rate of 10 nm/min or more, the metal film can be prevented from delamination caused by hydrogen generation.

For productivity, the rate of deposition of the metal film by the electroless plating preferably has an upper limit of 25 nm/min or less, more preferably 20 nm/min or less.

The deposition of the metal film by the electroless plating is preferably performed, for example, at a temperature of 20°C or more and 80°C or less until the metal film reaches a predetermined thickness. The thickness of the metal film formed by the electroless plating is preferably 100 nm or more and 200 nm or less in order to prevent pinhole formation due to insufficient deposition and to prevent gas trapping due to deposition for a long period of time.

The electroless plating may also be a method that includes using a chemically reducing agent-free plating solution to deposit a metal film with the aid of the difference between the oxidation-reduction potentials of the metal being deposited and the metal contained in the substrate surface.

### (Electroplating)

The electroplating may be a method that includes depositing a metal film on the surface of the substrate under application of an external current.

The electroplating may be performed using a known technique for depositing copper, nickel, silver, gold, tin, zinc, iron, lead, or any alloy thereof to form a metal film. The plating solution may be, for example, a copper plating solution containing copper sulfate, sulfuric acid, sodium chloride, and an organic sulfur compound. In this case, the organic sulfur compound is preferably a compound containing sulfur with low oxidation number, such as an organic sulfide or disulfide.

When the electroless plating performed on the surface of the oxide film to form a metal film is followed by the electroplating to form a metal film, heat treatment for drying is preferably performed after the electroless plating. The heat treatment after the electroless plating may be performed, for example, at a temperature of 100°C or more and 250°C or less for 1 to 120 minutes.

### <Metal Film Baking Step (S4)>

The metal film baking step (S4) includes baking the metal film formed in the metal film forming step (S3). According to the present invention, increased adhesion is achieved between the substrate and the metal layer, so that, when the metal film is baked, the metal layer can have a higher peel strength to the substrate.

The metal film baking step may use any baking temperature (second baking temperature) that allows an increase in the adhesion between the metal film and the substrate, which may be, for example, 250°C or more, more preferably 300°C or more. In particular, a second baking temperature of 250°C or more can increase the adhesion between the metal film and the oxide layer, so that the metal film can have further increased adhesion to the substrate.

On the other hand, the second baking temperature may have an upper limit of, for example, 500°C or less, more preferably 400°C or less.

In the metal film baking step, the baking time period (second baking time period) may be selected depending on the type of the substrate, the plated metal, the thickness of the plated metal layer, and the second baking temperature. For example, it may be 5 minutes or more, more preferably 10 minutes or more. On the other hand, the second baking time period may be, for example, 120 minutes or less, more preferably 60 minutes or less.

The metal film baking step may include heating with a temperature gradient until a predetermined second baking temperature is reached. In this case, heating with a temperature gradient may include raising the temperature at a constant rate until the second baking temperature is reached, changing the rate of temperature rise during at least part of the temperature gradient, or setting a time period for which a certain temperature is maintained during part of the temperature gradient. After the heating with a temperature gradient, the baking is preferably performed at a predetermined second baking temperature.

In particular, the temperature gradient to the second baking temperature is preferably 50°C/minute or less, more preferably 20°C/minute or less. Accordingly, the temperature is slowly raised, which can reduce internal stress in the oxide film and the metal film, such as distortion caused by the difference in thermal expansion between the metal film and the substrate, so that the metal film can have further increased adhesion to the substrate. In addition, the solvent and other components can be slowly evaporated from the metal film, which leads to a reduction in baking-induced damage to the metal film.

### <Properties and Applications of Metal-Plated Structure>

The metal-plated structure obtained according to the present invention has a surface metal film with high peel strength to the substrate. More specifically, the metal-plated structure obtained according to the present invention preferably requires a force (90° peel strength) of 0.3 kN/m or more, more preferably 0.8 kN/m or more to allow a pressure-sensitive adhesive thereon to be peeled off in a direction at 90° from the substrate after the pressure-sensitive adhesive is attached to the metal film of the metal-plated structure. This means that the metal film resists delamination from the oxide film so that the metal film in the metal-plated structure has high mechanical durability.

According to the present invention, the metal-plated structure is obtained using the coating agent for forming an oxide film, which contains titanium and silicon atoms in a predetermined ratio, so that the oxide film can be easily formed without blister formation and other defects on the surface of the substrate. In particular, the coating agent used to form an oxide layer may have a ratio of the number of titanium atoms to the number of silicon atoms of 10:1 or less than 10:1. In this case, even when the oxide layer formed is as thin as 100 nm or less, specifically as thin as 60 nm or less, a metal film formed on the surface of the oxide layer can have a peel strength as high as 0.8 kN/m or more to the substrate.

The metal-plated structure can find a wide range of applications where metal is deposited on inorganic substrates such as glass. In particular, when formed using a non-conducting or semiconductor substrate, the metal-plated structure is preferably employed in printed electronic circuit applications, specifically, applications including interposers, flat panel displays, and radio-frequency identification (RFID) antennas. In these applications, highly reliable electronic circuits will be achieved.

### EXAMPLES

Hereinafter, the present invention will be described in more detail with reference to examples, which are not intended in any way to limit the present invention.

### <<Examples 1 to 17 and Comparative Example 1>>

Oxide film-forming coating agents (Nos. 1 to 14) were prepared according to the procedure described below, and electroless processes (Nos. A and B) were performed using the oxide film-forming coating agents.

### <Preparation of Oxide Film-Forming Coating Agents (Nos. 1 to 8)>

Each component used in the preparation of oxide film-forming coating agents (Nos. 1 to 8) are shown in detail below. The content of each component is shown in Table 1.

**[Table 1]**

| | No.1 | No.2 | No.3 | No.4 | No.5 | No.6 | No.7 | No.8 |
|---|---|---|---|---|---|---|---|---|
| **(A) Oxide/Oxide Precursor** | | | | | | | | |
| Titanium tetraisopropoxide [mL] | 35.0 | 35.0 | 35.0 | 35.0 | 35.0 | 35.0 | 35.0 | 35.0 |
| Comp. 5221 [mL] | 0.0 | 2.8 | 5.7 | 8.5 | 11.4 | 15.0 | 22.7 | 45.5 |

| **(B) Solvent** | | | | | | | | |
|---|---|---|---|---|---|---|---|---|
| Ethanol [mL] | 250.0 | 250.0 | 250.0 | 250.0 | 250.0 | 250.0 | 250.0 | 250.0 |
| n-butanol [mL] | 50.0 | 50.0 | 50.0 | 50.0 | 50.0 | 50.0 | 50.0 | 50.0 |
| 2-n-butoxyethanol [mL] | 50.0 | 50.0 | 50.0 | 50.0 | 50.0 | 50.0 | 50.0 | 50.0 |
| Ethyl lactate [mL] | 50.0 | 50.0 | 50.0 | 50.0 | 50.0 | 50.0 | 50.0 | 50.0 |

| **(C) Other Components** | | | | | | | | |
|---|---|---|---|---|---|---|---|---|
| 3-hydroxy-2-butanone (chelating agent) [mL] | 21.0 | 21.0 | 21.0 | 21.0 | 21.0 | 21.0 | 21.0 | 21.0 |
| Total [mL] | 456.0 | 458.8 | 461.7 | 464.5 | 467.4 | 471.0 | 478.7 | 501.5 |
| Ti atoms [mmol/L] | 258.8 | 257.2 | 255.6 | 254.0 | 252.5 | 250.5 | 246.5 | 235.3 |
| Cu atoms [mmol/L] | 0.0 | 0.0 | 0.0 | 0.0 | 0.0 | 0.0 | 0.0 | 0.0 |
| Si atoms [mmol/L] | 0.0 | 17.8 | 36.1 | 53.5 | 71.3 | 93.1 | 138.6 | 265.2 |
| Si/(Ti+Cu) ratio | 0.00 | 0.07 | 0.14 | 0.21 | 0.28 | 0.37 | 0.56 | 1.12 |

In the column for (A) Oxide/Oxide Precursor, "Comp. 5221" represents an alcohol solution of Si oligomers (product name: Comp. 5221 manufactured by JCU Corporation).

Oxide film-forming coating agents (Nos. 1 to 8) were prepared by mixing the materials listed in Table 1 so that the contents shown in Table 1 were reached.

### <Preparation of Oxide Film-Forming Coating Agents (Nos. 9 to 14)>

Each component used in the preparation of oxide film-forming coating agents (Nos. 9 to 14) are shown in detail below. The content of each component is shown in Table 2.

**[Table 2]**

| | No.9 | No.10 | No.11 | No.12 | No.13 | No.14 |
|---|---|---|---|---|---|---|
| **(A) Oxides/Oxide Precursor** | | | | | | |
| Titanium tetraisopropoxide [mL] | 49.7 | 49.7 | 74.0 | 74.0 | 26.0 | 26.0 |
| Anhydrous copper(II) acetate [g] | 13.6 | 13.6 | 0.0 | 0.0 | 6.8 | 6.8 |
| 3-aminopropyl triethoxysilane [mL] | 0.0 | 20.5 | 0.0 | 0.0 | 0.0 | 0.0 |
| Tetraethoxysilane [mL] | 0.0 | 0.0 | 0.0 | 20.0 | 0.0 | 0.0 |
| Comp. 5221 [mL] | 0.0 | 0.0 | 0.0 | 0.0 | 0.0 | 15.0 |

| **(B) Solvent** | | | | | | |
|---|---|---|---|---|---|---|
| 2-n-butoxyethanol [mL] | 100.0 | 100.0 | 100.0 | 100.0 | 0.0 | 0.0 |
| Ethyl lactate [mL] | 0.0 | 0.0 | 0.0 | 0.0 | Balance | Balance |
| Isopropanol [mL] | 200.0 | 200.0 | 0.0 | 0.0 | 0.0 | 0.0 |
| N-methylpyrrolidone [mL] | 0.0 | 0.0 | 0.0 | 0.0 | 125.0 | 125.0 |
| Distilled water [mL] | Balance | Balance | Balance | Balance | 0.0 | 0.0 |
| γ-butyrolactone [mL] | 0.0 | 0.0 | 0.0 | 0.0 | 40.0 | 40.0 |

| **(C) Other Components** | | | | | | |
|---|---|---|---|---|---|---|
| Triton X-100 (surfactant) [g] | 0.1 | 0.1 | 0.1 | 0.1 | 0.0 | 0.0 |
| Ethyl 3,4-dihydroxybenzoate (chelating agent) [g] | 0.0 | 0.0 | 0.0 | 0.0 | 23.0 | 23.0 |
| Triethanolamine (chelating agent) [mL] | 11.2 | 11.2 | 0.0 | 0.0 | 13.0 | 13.0 |
| 2-hydroxyisobutyric acid (chelating agent) [g] | 26.0 | 26.0 | 0.0 | 0.0 | 0.0 | 0.0 |
| Lactic acid (chelating agent) [mL] | 0.0 | 0.0 | 22.5 | 22.5 | 0.0 | 0.0 |
| Methoxyethoxyacetic acid (chelating agent) [mL] | 0.0 | 0.0 | 0.0 | 0.0 | 6.5 | 6.5 |
| PAC-B (photosensitive material) [g] | 0.0 | 0.0 | 0.0 | 0.0 | 20.0 | 20.0 |
| Total [mL] | 1000.0 | 1000.0 | 1000.0 | 1000.0 | 1000.0 | 1000.0 |
| Ti atoms [mmol/L] | 175.0 | 175.0 | 250.0 | 250.0 | 87.5 | 87.5 |
| Cu atoms [mmol/L] | 75.0 | 75.0 | 0.0 | 0.0 | 37.5 | 37.5 |
| Si atoms [mmol/L] | 0.0 | 87.5 | 0.0 | 90.0 | 0.0 | 43.7 |
| Si/(Ti+Cu) ratio | 0.00 | 0.35 | 0.00 | 0.36 | 0.28 | 0.35 |

In the column for (A) Oxide/Oxide Precursor, "Comp. 5221" represents an alcohol solution of Si oligomers (product name: Comp. 5221 manufactured by JCU Corporation). The photosensitive material used was NQD ester (product name: PAC-B manufactured by Tokyo Ohka Kogyo Co., Ltd.).

Oxide film-forming coating agents (Nos. 9 to 14) were prepared by mixing the materials listed in Table 2 so that the contents shown in Table 2 were reached.

### <Electroless Process (No. A) Using Oxide Film-Forming Coating Agent>

The resulting oxide film-forming coating agent was subjected to a coating film forming step to form a coating film. More specifically, the coating agent was applied to a 50 x 50 x 0.7 mm substrate by dip coating and then dried at 50°C to form a coating film.

In this process, the substrate used was borosilicate glass (product name: Tempax) manufactured by Schott AG Corporation. Similar experiments were also carried out in which the substrates used for application of the oxide film-forming coating agents (Nos. 5 and 12) were respectively aluminoborosilicate glass (product name: EN-A1) manufactured by Asahi Glass Co., Ltd. and synthetic quartz glass (product name: Synthetic Quartz MT-WKS50PP01) manufactured by Monotech Co., Ltd. These substrates were subjected to coating film formation after being immersed in an aqueous solution of 200 g/L NaOH at 50°C for 10 minutes, then washed with water, and then air blow-dried.

In the dip coating, the substrate withdrawal rate was adjusted so that a 40 nm thick oxide film could be formed.

Subsequently, the coating film formed on the substrate was subjected to a coating film baking step to form an oxide film. This step included heating the interior of the furnace to raise the temperature to a baking temperature of 550°C (first baking temperature) with a temperature gradient of 10°C/minute; and then baking the coating film at the first baking temperature for 60 minutes (first baking time). The interior of the furnace was then allowed to naturally cool down to room temperature.

The resulting oxide film was subjected to an acid or base treatment step including immersing the oxide film together with the substrate in a base-containing treatment solution, which was followed by washing the oxide film with water. In this step, the treatment solution used was an alkaline solution (an aqueous solution of 0.25 mol/L tripotassium citrate). The treatment solution had a pH of 8. The oxide film was immersed together with the substrate for 2 minutes in the treatment solution heated at 40°C.

Subsequently, the oxide film was subjected to a catalyst depositing step including immersing the oxide film together with the substrate in a catalyst-containing solution, which was followed by washing the oxide film with water. In this step, an aqueous solution of a palladium complex containing an amino acid ligand (trade name: ES-300 manufactured by JCU Corporation) was used as a stock solution for the catalyst, which was diluted with water to 100 mL stock solution per liter prior to use. The oxide film was immersed together with the substrate for 3 minutes in the catalyst-containing treatment solution heated at 50°C. At this time, the amount (on a metal basis) of the catalyst deposited on the surface of the oxide film was as shown in Table 4 below.

The oxide film with the catalyst deposited thereon was immersed together with the substrate in a reducing agent-containing solution so that the palladium complex in the catalyst was reduced to metallic palladium. In this step, the reducing agent used was a solution of a mixture of ES-400A solution and ES-400B agent in water, in which the concentrations of ES-400A solution and ES-400B agent (both manufactured under the trade name ES-400 by JCU Corporation) were 10 mL/L and 14 g/L, respectively. The oxide film was immersed together with the substrate for 2 minutes in the treatment solution heated at 40°C.

After the catalyst was reduced, the oxide film was washed with water so that the reducing agent remaining unreacted was cleaned off. The oxide film was then subjected to a metal film forming step that included electroless plating to form a metal film and then electroplating to increase the thickness of the metal film.

The electroless plating included immersing the oxide film together with the substrate in an electroless copper plating solution (trade name: PB-507F manufactured by JCU Corporation) at 30°C for 8 minutes. In this step, a 150 nm thick metal film was deposited by the electroless plating, from which the rate of deposition of the metal film from the electroless copper plating solution was calculated to be 18 to 19 nm/min. The metal film resulting from the electroless plating was washed with water, air blow-dried, and then dried by heat treatment at 120°C for 10 minutes, which was followed by electroplating.

The electroplating included depositing a 20 µm thick metallic copper film at a current density of 3 A/dm² from an electrolytic copper plating solution (trade name: CU BRITE 21 manufactured by JCU Corporation). After the electroplating, the oxide film was washed with water and then air blow-dried.

Subsequently, a metal film baking step was performed, which included baking the metal film resulting from the plating to obtain a metal-plated structure. This step included heating the interior of the furnace in an inert atmosphere of nitrogen gas or forming gas to raise the temperature to a baking temperature of 400°C (second baking temperature) with a temperature gradient of 10°C/minute; and then baking the metal film at the second baking temperature for 60 minutes (second baking time). Thereafter, the interior of the furnace was allowed to naturally cool down to room temperature.

### <Electroless Process (No. B) Using Oxide Film-Forming Coating Agent>

Similar to the electroless process (No. A), the resulting oxide film-forming coating agent was subjected to a coating film forming step to form a coating film.

In this process, the substrate used was borosilicate glass (product name: Tempax, containing alkali metals) manufactured by Schott AG Corporation. Similar experiments were also carried out in which the oxide film-forming coating agent (No. 14) was applied to each of the following substrates: aluminoborosilicate glass (product name: EN-A1, free of alkali metals) manufactured by Asahi Glass Co., Ltd.; synthetic quartz glass (free of alkali metals); and a monocrystalline Si wafer with a 10 nm thick SiO₂ film on its surface.

Subsequently, the coating film formed on the substrate was subjected to a coating film baking step to form an oxide film. In this step, the coating film on the alkali metal-containing borosilicate glass was baked at a baking temperature of 400°C (first baking temperature), and the coating films on the alkali metal-free aluminoborosilicate glass, synthetic quartz glass, and monocrystalline Si wafer were baked at a baking temperature of 500°C (first baking temperature). The temperature gradient to the first baking temperature and the duration at the first baking temperature were the same as those in the electroless process (No. A).

The resulting oxide film was immersed together with the substrate in a reducing agent-containing treatment solution so that copper oxide in the oxide film was reduced. The oxide film was then washed with water. The treatment solution used was an aqueous solution containing NaBH₄ at a concentration of 2 g/L as a reducing agent. The oxide film was immersed together with the substrate for 2 minutes in the treatment solution heated at 50°C.

After the catalyst was reduced, the oxide film was washed with water so that the reducing agent remaining unreacted was cleaned off. The oxide film was then subjected to a metal film forming step that included electroless plating to form a metal film and then electroplating to increase the thickness of the metal film.

The electroless plating included immersing the oxide film together with the substrate in an electroless copper plating solution at 60°C for 8 minutes. The electroless copper plating solution used had the composition shown in Table 3 below.

**[Table 3]**

| Components | Concentration |
|---|---|
| Copper sulfate pentahydrate (CuSO₄▪5H₂O) | 3.5g/l |
| Ethylenediaminetetraacetic acid tetrasodium tetrahydrate (EDTA-4Na▪4H₂O) | 14g/l |
| 2,2'-bipyridine | 10mg/l |
| Polyethylene glycol (average molecular weight 1,000) | 50mg/l |
| Aqueous formaldehyde solution (concentration 35%) | 8ml/l |
| Aqueous NaOH solution (100 g/L) | In an amount to adjust the pH of the electroless copper plating solution to 12 at room temperature |
| Pure water | Balance |

A 120 nm thick metal film was deposited by the electroless plating, from which the rate of deposition of the metal film by the electroless plating was calculated to be 17 nm/min. After the electroless plating, the oxide film was washed with water, then air blow-dried, and then subjected to heat treatment at 120°C for 10 minutes, which was followed by electroplating.

The electroplating included depositing a 20 µm thick metallic copper film at a current density of 3 A/dm² from an electrolytic copper plating solution (trade name: CU BRITE 21 manufactured by JCU Corporation). After the electroplating, the oxide film was washed with water and air blow-dried.

Subsequently, a metal film baking step was performed, which included baking the metal film resulting from the plating to obtain a metal-plated structure. This step included heating the interior of the furnace in an inert atmosphere of nitrogen gas or forming gas to raise the temperature to a baking temperature of 400°C (second baking temperature) with a temperature gradient of 10°C/minute; and then baking the metal film at the second baking temperature for 60 minutes (second baking time). Thereafter, the interior of the furnace was allowed to naturally cool down to room temperature.

### <Evaluation of the Peel Strength of Metal-Plated Structures>

The oxide film-forming coating agents (Nos. 1 to 14) were subjected to the electroless processes (Nos. A and B) to form metal-plated structures. The metal film in each resulting metal-plated structure was subjected to a 90° peel test (according to JIS H 8630) for evaluating the peel strength of the metal film. The 90° peel test was performed in an environment at an air temperature of 24°C and a relative humidity of 30% or less.

Table 4 shows the types of the oxide film-forming coating agent and the electroless process used in each example, the amount of the palladium catalyst deposited in each example, and the results of the 90° peel test.

**[Table 4]**

| | Oxide film-forming coating agent | Electroless process | Amount of Pd catalyst deposited [mg/m²] | Adhesion strength [kN/m] | Notes |
|---|---|---|---|---|---|
| Example 1 | No.1 | No.A | 1.3 | 0.3 | |
| Example 2 | No.2 | No.A | 1.5 | 0.4 | |
| Example 3 | No.3 | No.A | 2.2 | 0.8 | |
| Example 4 | No.4 | No.A | 2.3 | 1.0 | |
| Example 5 | No.5 | No.A | 2.4 | 1.1 | |
| Example 6 | No.5 | No.A | 2.1 | 1.1 | Example with the oxide layer thickness changed to 30 nm |
| Example 7 | No.5 | No.A | 2.5 | 1.1 | Example with the oxide layer thickness changed to 46 nm |
| Example 8 | No.5 | No.A | 2.3 | 1.0 | Example with the second baking temperature changed to 350°C |
| Example 9 | No.5 | No.A | 1.3 | 0.8∼0.9 | Example with the catalyst changed to alkaline Pd catalyst solution PB-333(*) |
| Example 10 | No.6 | No.A | 2.3 | 1.0 | |
| Example 11 | No.7 | No.A | 0.7 | - | Partial electroless deposition of copper |
| Comparative Example 1 | No.8 | No.A | 0.4 | - | Failure of electroless deposition of copper |
| Example 12 | No.9 | No.B | - | 0.3 | |
| Example 13 | No.10 | No.B | - | 0.9 | |
| Example 14 | No.11 | No.A | 1. 8 | 0.3 | |
| Example 15 | No.12 | No.A | 2.3 | 1.0 | |
| Example 16 | No.13 | No.B | - | 0.3 | Example with the electroless bath temperature changed to 70°C |
| Example 17 | No.14 | No.B | - | 1.1 | Example with the electroless bath temperature changed to 70°C |

| | | | | | |
|---|---|---|---|---|---|
| *PB-333 (trade name) manufactured by JCU Corporation | | | | | |

The results in Table 4 indicate that, in Examples 1 to 11, 14, and 15, the palladium complex was deposited at least partially on the oxide layer and the palladium complex-carrying portion contained, on a metal basis, 0.5 mg/m² or more of deposited palladium, on which the metal film was deposited. In Examples 12, 13, 16, and 17, the metal film was deposited on copper atoms contained in the oxide layer. The deposited metal film adhered to the substrate with an adhesion strength of at least 0.3 [kN/m], which indicates that the adhesion strength of the oxide film to the substrate was at least 0.3 [kN/m]. On the other hand, in Comparative Example 1, almost no palladium complex was deposited on the oxide layer, and no metal film was deposited. This suggests that such an advantageous effect that an oxide film on which plating is possible is formed with high adhesion to a substrate can be produced when the ratio of the total number of titanium and copper atoms to the number of silicon atoms is 3:2 or more than 3:2.

When the oxide film-forming coating agents (Nos. 5, 12, and 14) were applied to the aluminoborosilicate glass and synthetic quartz glass substrates in place of the borosilicate glass substrate, similar results about the amount of deposited palladium in the palladium complex-carrying portion and the adhesion strength of the metal film to the substrate were obtained to those obtained using the borosilicate glass substrate. Also when the oxide film-forming coating agent (No. 14) was applied to the monocrystalline Si wafer with an SiO₂ film deposited thereon, in place of the borosilicate glass substrate, similar results about the amount of deposited palladium and the adhesion strength of the metal film to the substrate were obtained to those obtained using the borosilicate glass substrate. This suggests that such an advantageous effect that an oxide film on which plating is possible can be formed with high adhesion to a substrate does not depend on the composition or crystal condition of the substrate surface.

### <<Comparative Example 2>>

For comparison, preparation of a oxide film-forming coating agent was attempted as disclosed in Example 3 in Japanese Unexamined Patent Application Publication No. 2016-533429 by dissolving zinc acetate dihydrate (Zn(OAc)₂·2H₂O) at 0.5 mol/L in ethanol. Unfortunately, the resulting preparation, in which precipitation occurred, did not provide a stable solution or dispersion.

This suggests that such an advantageous effect that a highly stable coating agent is obtained can be produced when at least one of titanium and copper atoms is added in the form of an oxide or oxide precursor to the coating agent.

### <<Comparative Example 3>>

An oxide film-forming coating agent was prepared as a uniform solution by dissolving zinc acetate dihydrate (Zn(OAc)₂·2H₂O) and methoxyethoxyacetic acid each at 0.5 mol/L in ethanol.

A substrate was prepared as follows. A 50 x 50 x 0.7 mm borosilicate glass sheet (product name: Tempax) manufactured by Schott AG Co., Ltd. was immersed in an aqueous solution of 200 g/L NaOH at 50°C for 10 minutes, then washed with water, and then air blow-dried.

The oxide film-forming coating agent shown above was applied to the substrate by dip coating at a withdrawal rate of 10 cm/minute and then dried at a temperature of 250°C for 15 minutes. This process was repeated three times to form a coating film.

Subsequently, the coating film formed on the substrate was baked to form an oxide film. The baking of the coating film included heating the interior of the furnace to raise the temperature to a baking temperature of 500°C with a temperature gradient of 4°C/minute and then baking the oxide film at the baking temperature 500°C for 60 minutes. Thereafter, the interior of the furnace was allowed to naturally cool down to room temperature.

Subsequently, the oxide film was immersed together with the substrate in an aqueous solution containing 100 ppm of Na₂PdCl₄ as a catalyst at room temperature for 30 seconds and then washed with water. In this case, metallic palladium was produced on the surface of the oxide film without reduction of palladium ions to metallic palladium.

The oxide film with the reduced catalyst was washed with water so that the reducing agent remaining unreacted was cleaned off. The oxide film was then subjected to a metal film forming step that included electroless plating to form a metal film and then electroplating to increase the thickness of the metal film.

The electroless plating included immersing the oxide film together with the substrate in an electroless copper plating solution (trade name: PB-507F manufactured by JCU Corporation) at 37°C for 5 minutes. In this step, a 400 nm thick metal film was deposited by the electroless plating, from which the rate of deposition of the metal film from the electroless copper plating solution was calculated to be 80 nm/min. After the electroless plating, the oxide film was washed with water, air blow-dried, and then heat-treated at 120°C for 10 minutes and then at 180°C for 30 minutes, which was followed by electroplating.

The electroplating included depositing a 20 µm thick metallic copper film at a current density of 2.0 A/dm² from an electrolytic copper plating solution (trade name: CU BRITE 21 manufactured by JCU Corporation). After the electroplating, the oxide film was washed with water and then air blow-dried.

Subsequently, the metal film resulting from the plating was baked to form a metal-plated structure. The baking of the metal film included heating the interior of the furnace in an inert atmosphere of nitrogen gas or forming gas to raise the temperature to a baking temperature of 400°C with a temperature gradient of 10°C/minute; and then baking the metal film at the baking temperature 400°C for 60 minutes. Thereafter, the interior of the furnace was allowed to naturally cool down to room temperature.

The resulting metal-plated structure showed blister formation between the substrate and the metal film, which disabled the 90° peel test.

This suggests that such an advantageous effect that higher adhesion is achieved between the substrate and the metal film can also be produced when at least one of titanium and copper atoms is added in the form of an oxide or oxide precursor to the coating agent.

### <<Reference Example 1>>

A metal film resulting from electroless plating and electroplating was baked by a process that included raising the temperature to 120°C, holding the temperature at 120°C for 10 minutes, then raising the temperature to 180°C, holding the temperature at 180°C for 30 minutes, and then baking the metal film at a baking temperature of 350°C for 30 minutes. A metal-plated structure was formed under the same conditions as those in Comparative Example 3, except for the above conditions.

The resulting metal-plated structure showed a 90° peel test result of 0.65 [kN/m]. Unfortunately, the component of the oxide film dissolved into the electroless plating solution, which made it difficult to deposit the metal film by the electroless plating.

### <<Reference Example 2>>

A metal film resulting from electroless plating and electroplating was baked by a process that included raising the temperature to 120°C, holding the temperature at 120°C for 10 minutes, then raising the temperature to 180°C, holding the temperature at 180°C for 30 minutes, then raising the temperature to 350°C, holding the temperature at 350°C for 30 minutes, then raising the temperature to a baking temperature of 400°C, and baking the metal film at the baking temperature 400°C for 60 minutes. A metal-plated structure was formed under the same conditions as those in Comparative Example 3, except for the above conditions.

The resulting metal-plated structure showed a 90° peel test result of 0.7 [kN/m]. Unfortunately, as in Reference Example 1, the component of the oxide film dissolved into the electroless plating solution, which made it difficult to deposit the metal film by the electroless plating.

The results in Reference Examples 1 and 2 suggest that such an advantageous effect that a reduction is achieved in dissolution of the component of the oxide film into an electroless plating solution can also be produced when at least one of titanium and copper atoms is added in the form of an oxide or oxide precursor to the coating agent.

## Claims

1. A liquid coating agent for forming an oxide film on a substrate,
the liquid coating agent comprising titanium atoms as an essential component and optionally comprising silicon and copper atoms, wherein
the ratio of the total number of the titanium and copper atoms to the number of the silicon atoms is between 3:2 and 1:0.

2. The coating agent for forming an oxide film according to claim 1, wherein the ratio of the total number of the titanium and copper atoms to the number of the silicon atoms is between 7:3 and 20:1.

3. The coating agent for forming an oxide film according to claim 1 or 2, further comprising a solvent comprising at least one of water, alcohols, ketones, ethers, esters, aromatic compounds, and nitrogen-containing solvents.

4. The coating agent for forming an oxide film according to any one of claims 1 to 3, which is for use in improving adhesion between the substrate and a metal film.

5. A method for producing an oxide film, comprising: the steps of applying the coating agent for forming an oxide film according to any one of claims 1 to 4 to a substrate; and heating the coating agent to form an oxide film.

6. A method for producing a metal-plated structure by forming a metal film on at least part of a surface of a substrate with an oxide film interposed between the substrate and the metal film, the method comprising:
an oxide film forming step that comprises applying the coating agent for forming an oxide film according to any one of claims 1 to 4 to a surface of the substrate to form an oxide film;
a metal film forming step that comprises forming a metal film on the oxide film; and
a metal film baking step that comprises baking the metal film.

7. The method according to claim 6, wherein the metal film forming step comprises depositing metal on a catalyst deposited on the oxide film to form the metal film.

8. The method according to claim 7, wherein copper (Cu), a metal element having a standard electrode potential positively more than that of copper (Cu), or a compound of copper and/or the metal element is used as the catalyst.

9. The method according to claim 8, wherein the catalyst is deposited in an amount of 0.5 mg/m² or more on a metal basis on the oxide film.
